# EUROPÄISCHE PATENTSCHRIFT

(11) **EP 3 174 948 B1**
(45) Veröffentlichungstag und Bekanntmachung des Hinweises auf die Patenterteilung: **09.06.2021**
(21) Anmeldenummer: 15742296.5
(22) Anmeldetag: 28.07.2015
(51) Int. Cl.: C09D 183/16, C08L 83/16

(54) **HYBRIDMATERIAL ZUR VERWENDUNG ALS BESCHICHTUNGSMITTEL IN OPTOELEKTRONISCHEN BAUTEILEN**
HYBRID MATERIAL FOR USE AS A COATING AGENT IN OPTOELECTRONIC COMPONENTS
MATÉRIAU HYBRIDE DESTINÉ À ÊTRE UTILISÉ EN TANT QU'AGENT DE REVÊTEMENT DANS DES COMPOSANTS OPTOÉLECTRONIQUES

(30) Priorität: 29.07.2014 EP 14178994
(43) Veröffentlichungstag der Anmeldung: 07.06.2017
(73) Patentinhaber: Merck Patent GmbH, 64293 Darmstadt (DE)
(72) Erfinder: GROTTENMÜLLER, Ralf, 65199 Wiesbaden (DE); KARUNANANDAN, Rosalin, 60486 Frankfurt am Main (DE); KITA, Fumio, 65185 Wiesbaden (DE); LENZ, Helmut, 65760 Eschborn (DE); WAGNER, Dieter, 65207 Wiesbaden (DE); DRESEL, Andreas, 65510 Hünstetten (DE)
(74) Vertreter: B2B Patents
(86) Internationale Anmeldenummer: PCT/EP2015/067304
(87) Internationale Veröffentlichungsnummer: WO 2016/016260

(56) Entgegenhaltungen:
- WO-A1-2013/046662
- WO-A1-2014/050769
- JP-A- 2003 050 385
- KR-A- 20140 068 547
- US-B1- 6 501 014

## Beschreibung

Die Erfindung betrifft die Verwendung von speziellen Organopolysilazan-Hybridmaterialien als Beschichtungsmittel in optoelektronischen Bauteilen, Verfahren zur Beschichtung von Substraten mit den speziellen Hybridmaterialien und optoelektronische Bauelemente, beschichtet mit den Hybridmaterialien.

Polysilazane sind seit einigen Jahren als Beschichtungsmittel für verschiedene Verwendungen bekannt.

Für manche Anwendungen, beispielsweise in Solarzellen (WO 2010/105 796 und WO 2010/105 798), als Korrosionsschutzschichten (WO 2007/096 070) oder als Gasbarriereschichten (WO 2007/012 392), werden die Polysilazanbeschichtungen nach dem Aufbringen weiter zu keramischen Beschichtungen auf SiO₂-Basis gebrannt.

Bei anderen Anwendungen, beispielsweise als Beschichtungen für Metall- und Polymeroberflächen (WO 2007/028 511), als selbstreinigende Schutzschichten insbesondere für Autofelgen (WO 2005/085 375), zur Beschichtung von Metallbändern (WO 2006/050 813), zur Beschichtung von Folien (WO 2006/056 285) oder in Lacken (WO 2008/138 610), werden die Polysilazanschichten nach dem Aufbringen zwar gehärtet, die Struktur des Polysilazans bleibt dabei jedoch im Wesentlichen erhalten.

In allen genannten Dokumenten ist beschrieben, dem Organopolysilazan gegebenenfalls Nanopartikel von anorganischen Oxiden zuzusetzen.

JP-A 2003 050 385 offenbart eine Beschichtung für eine Flüssigkristallzelle, die auf Basis eines Polysilazans, das obeflächenmodifizierte ferroelektrische Partikel enthält, erhalten werden kann. Das Polysilazan wird dabei zu einem keramischen Material gebrannt.

KR-A 2014 0068547 offenbart SiO₂ Filme, die aus Perhydro-Polysilazan und anorganischen, oberflächenmodifizierten Partikeln hergestellt und in Elektrolumineszenzvorrichtungen eingesetzt werden.
WO 2013/046 662 offenbart eine LED, die eine keramische Schicht mit einem Fluoreszenzmaterial und anorganischen Oxidpartikeln enthält, wobei die keramische Schicht aus Polysilazanen erhalten werden kann.
Es wurde nun gefunden, dass sich bestimmte Hybridmaterialien aus Organopolysilazanen und oxidischen anorganischen Nanopartikeln in besonderer Weise zur Herstellung von Beschichtungen in optoelektronischen Bauteilen geeignet sind.
Gegenstand der Erfindung ist daher die Verwendung eines Hybridmaterials, enthaltend
a) ein Organopolysilazanmaterial nach Anspruch 1 und
b) mindestens ein oberflächenmodifiziertes nanoskaliges anorganisches Oxid als Beschichtungsmaterial zur Herstellung transparenter Schichten mit einer Dicke von weniger als 500 µm in optoelektronischen Bauteilen.
Weiterhin Gegenstand der Erfindung ist ein Verfahren zum Aufbringen einer transparenten Schicht mit einer Dicke von < 500 µm in einem optoelektronischen Bauelement, wobei
I) ein erfindungsgemäßes Hybridmaterial auf eine Fläche in dem optoelektronischen Bauelement aufgebracht,
II) getrocknet, und
III) gegebenenfalls gehärtet wird.
Die Verwendung der erfindungsgemäß eingesetzten Hybridmaterialien bietet verschiedene Vorteile. Sie sind gekennzeichnet durch defektfreie Beschichtungen ohne Rissbildung von Schichten mit einer Schichtdicke von bis zu 500 µm bei Temperaturen bis zu 200°C. Erfindungsgemäße Beschichtungen weisen bevorzugt eine gleichmäßige Schichtdicke mit einer Schichtdickenschwankung relativ zur mittleren Schichtdicke von ≤ 5% bei einer absoluten Schichtdicke von 0,1 µm bis 500 µm auf.
Erfindungsgemäße Beschichtungen zeichnen sich durch einen hohen Brechungsindex aus und verändern sich nicht im Absorptionsverhalten.
Erfindungsgemäß hergestellte Beschichtungen zeigen bevorzugt einen geringen Gewichtsverlust von ≤ 10%, bevorzugt ≤ 5%, beim Aushärten unter höherer Temperatur bis zu 200°C.

Die erfindungsgemäß eingesetzten Organopolysilazane enthalten Wiederholeinheiten der Formel (I),

- [SiRR'-NH] (I)

wobei
R, R' gleich oder verschieden H, Methyl, Ethyl, geradkettiges oder verzweigtes C₃-C₈-Alkyl, C₃-C₈-Cycloalkyl, C₂-C₆-Alkenyl oder Aryl
bedeuten, wobei R und R' nicht gleichzeitig H sein können.
Bevorzugt sind Organopolysilazane der Formel (I), worin
R, R' gleich oder verschieden H, Methyl, Ethyl, geradkettiges, verzweigtes oder cyclisches C₃-C₈-Alkyl, Phenyl, Vinyl oder Aryl bedeuten.
Besonders bevorzugt sind Organopolysilazane der Formel (I), worin
R, R' gleich oder verschieden H, Methyl, Ethyl, n-Propyl, iso-Propyl, n-Butyl, iso-Butyl, Phenyl oder Vinyl bedeuten.
Ganz besonders bevorzugt sind Organopolysilazane der Formel (I), worin R, R' gleich oder verschieden H, Methyl oder Vinyl bedeuten.

Insbesondere bevorzugt sind Organopolysilazane der Formel (I), worin R, R' gleich oder verschieden H oder Methyl bedeuten.

Organopolysilazane der Formel (I), wobei mindestens 20 % der Wiederholeinheiten der Formel (I) mindestens eine intramolekulare Vernetzung sind in der vorliegenden Erfindung verwendet; bevorzugt sind weiterhin Organopolysilazane der Formel (I), wobei das Polysilazan ein mittleres Molgewicht M_{w} im Bereich von 3000 bis 100 000 g/mol aufweist und/oder
wobei das Polysilazan einen Anteil im Molgewichtsbereich von kleiner als 1000 g/mol von weniger als 10 Gew.-% aufweist.
Die erfindungsgemäß eingesetzten Polysilazane können flüssig oder fest sein, im letzteren Fall amorph oder kristallin.
Die durch die Wiederholeinheiten der Formel (I) angegebene Struktur der erfindungsgemäß eingesetzten Polysilazane entspricht einer vereinfachten Darstellung, basierend auf den eingesetzten Monomeren. Dem Fachmann ist bekannt, dass die Struktur der Polysilazane nicht nur linear ist sondern überwiegend aus diskreten und/oder kondensierten Ring- sowie dreidimensionalen Gerüststrukturen besteht. Die Polymere enthalten also neben "sekundären" Stickstoffatomen in Bezug auf Si (in -Si-NR-Si- Gruppen) auch "tertiäre" (Si-N(-Si)-Si) und primäre (NR₂-Si). Entsprechend können die Si-Atome neben "sekundären" in Bezug auf N (N-SiR₂-N) Gruppen auch "tertiäre" N₃SiR und "primäre" N-SiR₃ Gruppen enthalten. Die genaue Struktur kann z.B. von der Synthesemethode und der Natur der Reste R abhängen.
In einer besonders bevorzugten Ausführungsform ist das Polysilazan ein solches mit Wiederholeinheiten der Formel (II), 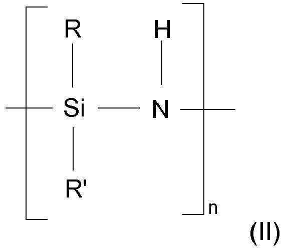 wobei R, R' wie oben definiert sind und n für eine ganze Zahl steht, die so gewählt ist, dass sich ein gewichtsmittleres Molgewicht im Bereich von 3.000 bis 100.000 g/mol ergibt.

In einer weiteren bevorzugten Ausführungsform ist das Polysilazan ein solches mit Wiederholeinheiten der Formel (III),

-(SiRR'-NH)ₙ₋-(SiR¹R²-NR³)ₚ- (III)

wobei
- R, R': wie oben definiert sind und
- R¹, R²: gleich oder verschieden H, C₁-C₈-Alkyl, C₃-C₈-Cycloalkyl, C₂-C₃-Alkenyl oder Phenyl und
- R³: H, C₁-C₈-Alkyl oder C₃-C₈-Cycloalkyl
bedeuten, mit der Maßgabe, dass mindestens einer der Reste R¹, R², R³ von den entsprechenden Resten R und R' verschieden ist,
und wobei n und p für ganze Zahlen stehen, die so gewählt sind, dass sich ein gewichtsmittleres Molgewicht im Bereich von 3.000 bis 100.000 g/mol ergibt.

In einer weiteren bevorzugten Ausführungsform ist das Polysilazan ein solches mit Wiederholeinheiten der Formel (IV)

-(SiRR'-NH)ₙ₋-(SiR¹R²-NR³)ₚ-(SiR⁴R⁵-NR⁶)_{q-} (IV)

wobei
- R, R': wie oben definiert sind,
- R¹, R², R⁴, R⁵,: gleich oder verschieden H, C₁-C₈-Alkyl, C₃-C₈-Cycloalkyl, C₂-C₃-Alkenyl oder Phenyl und
- R³, R⁶: H, C₁-C₈-Alkyl oder C₃-C₈-Cycloalkyl
bedeuten, mit der Maßgabe, dass die drei Wiederholeinheiten in mindestens einem der Reste verschieden sind,
und wobei n, p und q für ganze Zahlen stehen, die so gewählt sind, dass sich ein gewichtsmittleres Molgewicht im Bereich von 3.000 bis 100.000 g/mol ergibt.

Bei den erfindungsgemäß eingesetzten Polysilazanen weisen mindestens 20 % der Wiederholeinheiten der Formel (I) mindestens eine intramolekulare Vernetzung auf.

Die erfindungsgemäß eingesetzten Polysilazane haben vorzugsweise ein mittleres Molgewicht M_{w} im Bereich von 3000 bis 100 000 g/mol, besonders bevorzugt ein mittleres Molgewicht M_{w} im Bereich von 3000 bis 20 000 g/mol.

Bei den erfindungsgemäß eingesetzten Polysilazanen liegt der Anteil im Molgewichtsbereich von kleiner als 1000 g/mol, bevorzugt weniger als 10 Gew.-%, besonders bevorzugt bei weniger als 5 Gew.-%.

Erfindungsgemäß eingesetzte Polysilazane mit Wiederholeinheiten der Formel (I) sind im Prinzip bekannt (siehe z. B. die eingangs zitierte Literatur). In der Praxis erfolgt die Synthese der Polysilazane fast immer durch Umsetzung von Dichlorsilanen mit Ammoniak nach der allgemeinen Gleichung (I):

n R¹R²SiCl₂ + 3n NH₃ → -[SiR¹R²-NH-]ₙ + 2n NH₄Cl (I)

Durch überschüssigen Ammoniak wird das freiwerdende HCl als Ammoniumchlorid gebunden. Durch die Wahl der Art der Reste R bzw. durch Kombination verschiedener Dichlorsilane lässt sich entweder ein Perhydropolysilazan (PHPS) (ausschließlich SiH₂Cl₂) oder beliebig substituierte Organopolysilazane herstellen (z.B. SiMe₂Cl₂ und SiMeHCL₂ zur Herstellung des kommerziellen Produkts DURAZANE® 1033 bzw. Si(CH=CH₂)MeCl₂+SiMeHCl₂ zur Herstellung des kommerziellen Produkts DURAZANE® 1800, beide erhältlich von AZ Electronic Materials Germany GmbH, Wiesbaden, Deutschland).

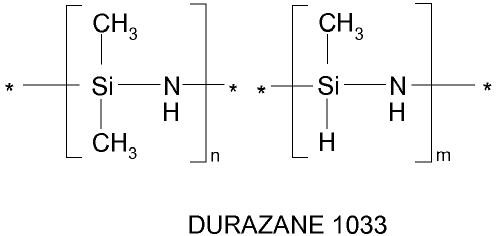

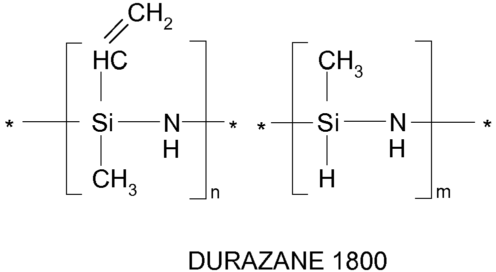

Die Synthese kann beispielsweise so ablaufen, dass flüssiger Ammoniak vorgelegt und Chlorsilan eingeleitet wird [z.B. US 6329487 B1]. Alternativ kann auch ein Lösemittel vorgelegt werden, in das gleichzeitig oder nacheinander in geeigneter Reihenfolge Chlorsilan und Ammoniak eingeleitet werden [z.B. EP 0341924 A2].

Allen bisherigen kommerziellen Synthesen ist gemeinsam, dass die so hergestellten Silazane nur relativ niedermolekulare Verbindungen sind. Grund hierfür ist die ausgeprägte Neigung von Silazanen Ringe zu bilden und nur in untergeordnetem Maß lineare Ketten. Nach dem oben genannten Verfahren hergestellte Silazane stellen somit lediglich niedermolekulare Oligomere dar und keine hochmolekularen Polymere. Von -[-Si(CH=CH₂)Me-NH-]ₙ- ist z.B. bekannt, dass es nahezu ausschließlich in Form von 6 und 8 Ringen vorliegt.

Das Problem, das die bekannten kommerziell erhältlichen Polysilazane mit sich bringen, besteht nun darin, dass beim Aushärten einer Beschichtung bei höheren Temperaturen und besonders bei Umwandlung zu Keramik, was Temperaturen von bis zu über 1000°C erfordert, ein nicht zu vernachlässigender Anteil des Materials während der Aushärtung verdampft. Als Folge dieses Materialverlusts kann es zu unkontrollierbaren Unebenheiten der Oberfläche dünner Schichten und außerdem zum eventuellen ungleichmäßigen Schrumpfen der Schichtdicke kommen, was Rissbildung zur Folge haben kann. Der verdampfte Anteil bringt zusätzlich das Problem mit sich, dass er an kalten Oberflächen wie z.B. Maschinenteilen wieder kondensiert und unerwünschte, nur schwer wieder zu entfernende Verunreinigungen hervorruft.

Erfindungsgemäß bevorzugt ist der Einsatz nachvernetzter Organopolysilazane.

Es sind bereits Methoden zum Nachvernetzen von Silazanen, d. h. zur Herstellung der erfindungsgemäß eingesetzten Polysilazane bekannt, die jedoch überwiegend bestimmte Nachteile aufweisen.

Silazane können prinzipiell durch Zugabe katalytischer Mengen starker Basen vernetzt werden. Möglich sind z.B. Alkyl-Lithium oder Alkyl-Natrium Verbindungen [D. Seyferth, Organometallics, 8, 1989, 1980-1986]. In EP 0342924 A2 wird die Nachbehandlung von -[SiHMe-NH]n- in einer THF Lösung durch Zugabe katalytischer Mengen Kaliumhydrid beschrieben. Zum Neutralisieren der Base muss anschließend Dimethylchlorsilan (SiMe₂HCl) zugegeben werden, wodurch - SiMe₂H-Seitenketten entstehen und KCl frei wird. In US 4720532 wird oligomeres Silazan ebenfalls durch KH in inertem Lösemittel umgesetzt, wobei eine Kontrolle des Vernetzungsgrades nur schwer möglich ist, da die Reaktion ohne Zugabe eines Neutralisierungsreagenzes bis zur Gelbildung durchläuft.

US 6329487 B1 beschreibt eine Nachvernetzung von Si-H und N-H Gruppen in Polysilazanen unter Ausbildung von Si-N Bindungen unter Wasserstoffabspaltung katalysiert durch Ammoniumchlorid nach einem speziellen, in diesem Dokument beschriebenen Mechanismus. Als Lösemittel wird flüssiger Ammoniak benötigt, in dem das solvatisierte Ammonium-Kation die eigentliche katalytisch aktive Spezies darstellt. Diese Methode ist auf flüssigen Ammoniak als Lösemittel beschränkt. Die Handhabung von flüssigem Ammoniak erfordert jedoch besonders in größerem Maßstab einen erheblichen Aufwand, was die technische Umsetzung dieser Methode wesentlich erschwert.

Von KION Corp. [J. Schwark, Mat.Res.Soc.Symp.Proc., 271, 1992, 807-812] wird die Vernetzung durch Bis-Isocyanante beschrieben. Die Reaktion von Silazenen mit Isocyanaten läuft wie in Gleichung (II) beispielhaft beschrieben ab:

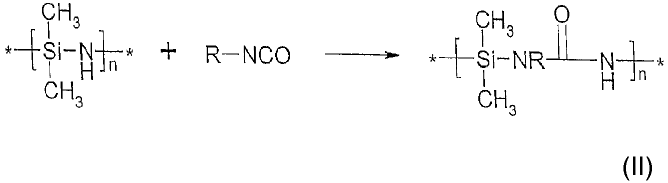

Nachteil dieser Methode ist der unvermeidliche Einbau von Harnstoffbindungen in die Hauptkette, so dass es sich nicht mehr um ein reines Polysilazan handelt.

L. Rosenberg [J.Am.Chem.Soc. 123/21, 2001, 5120-5121] und J.Y. Corey [Adv. In Organometallic Chem., 51, 2004, 1-52] beschreiben die Kopplung von Silanen unter Wasserstoffabspaltung katalysiert durch verschiedene Metallkomplexe nach:

2 R₃Si-H→R₃Si-SiR₃+H₂

Als Katalysatoren werden unter anderem Wilkinson-Katalysator [(PH₃P)₃RhCl] und Dimethyltitanocen [Cp₂TiMe₂] genannt. Die genannten Beispiele beschränken sich jedoch auf definierte niedermolekulare Moleküle. Es ist fraglich, ob auch höhermolekulare Polysilazane in dieser Weise kontrolliert reagieren.

Bekannt ist weiterhin die Vernetzung durch Einbau Bor-haltiger Brücken. In EP 0389084 A2 wird z.B. die Vernetzung Si-H funktioneller Polysilazane mit BCl₃ oder B(OMe)₃ beschrieben und in US 5364920 die Vernetzung von B-H funktionellen Vernetzern. Diese Methoden haben zwangsweise einen Einbau von Bor zu Folge, was nur unter der Voraussetzung sinnvoll ist, dass ohnehin eine Silizium-BorNitrid-artige Keramik hergestellt werden soll. Eine Verunreinigung mit Bor ist in den meisten Fällen jedoch nicht erwünscht.

US 2009/0112013 A1 beschreibt die Kopplung von Silanen und Siloxanen unter Wasserstoffabspaltung durch Belichten mit UV-Licht in Gegenwart des Eisenkatalysators CpDe(CO)₂Me nach 2 R₃Si-H→R₃Si-SiR₃+H₂. Es wird keine Aussage getroffen, ob neben den beschriebenen Silanen und Siloxanen auch H-funktionelle Silazane reagieren. Außerdem beschränken sich die in der Literatur genannten Beispiele auf wohldefinierte niedermolekulare Moleküle.

Es wurde gefunden, dass eine Vernetzungsreaktion von Polysilazanen, die N-H und SiH Bindungen enthalten, durch die katalytische Einwirkung von Fluoridionen gemäß der folgenden Gleichung (III) eine einfach durchzuführende und gut zu kontrollierende Reaktion zur Herstellung der erfindungsgemäß eingesetzten Polysilazane darstellt, d.h., das Molgewicht oligomerer Silazane wird erhöht und dadurch das Verdampfen während des Aushärtens bei hohen Temperaturen verhindert und die Beschichtungseigenschaften verbessert:

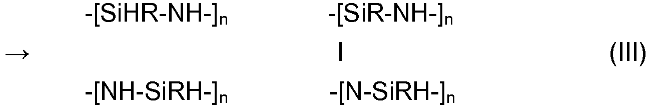

Die Vernetzung von Oligosilazanen unter Fluoridkatalyse ist in J. Mater. Chem A, 2013, 1, 15406 und WO 2014/328 174 beschrieben.

Das Fluoridion ist die katalytisch aktive Spezies in dieser Reaktion. Die Art des Gegenions und die Reaktionsbedingungen werden routinemäßig so eingestellt, dass eine genügende Löslichkeit von F⁻ gewährleistet ist. Geeignete Fluoridquellen sind bevorzugt Salze aus der Gruppe der Alkalimetallfluoride, NHₓR_{y}F wobei x 0 bis 4 ist und y 4 - x ist, oder harzgebundene Fluoride.

Beispiele für solche Salze sind CsF, NH₄F und Tetraalkylammoniumfluoride wie N(CH₃)₄F, N(C₂H₅)₄F und N(n-C₄H₉)₄F. Tetraalkylammoniumfluoride mit gemischten Gruppen R, wie Dodecyl-trimethylammoniumfluorid sind ebenfalls möglich. Weiterhin geeignet sind Arylammoniumfluoride, wie Benzyltrimethylammoniumfluorid.

Die Kombination aus Lösungsmittelpolarität und Reaktionstemperatur können routinemäßig so gewählt werden, dass die Reaktion nach einem gewissen Umsatz von selbst stoppt. Dadurch kann der Vernetzungsgrad gezielt eingestellt werden. Durch Abkühlen der Reaktionsmischung und Zugabe eines unpolaren Lösungsmittels wie n-Heptan oder t-Butylmethylether kann das Fluoridsalz vollständig ausgefällt und abfiltriert werden. Fluorid kann auch Zugabe von Salzen wie z.B. LiBr entfernt werden, welche schwerlösliche Fluoride bilden und somit das Fluorid ausfällen. Das so erhaltene Polysilazan, das die Bedingungen für die erfindungsgemäß einzusetzenden Polysilazane erfüllt, kann isoliert oder in Lösung als erfindungsgemäßes Beschichtungsmittel eingesetzt werden.

Erfindungsgemäß durch Fluoridkatalyse vernetzte Organopolysilazane zeichnen sich bevorzugt durch eine Viskosität von > 5000 mP•as aus oder sind Feststoffe. Die Viskosität wird mit einem Brookfield Rheometer R/S plus, Brookfield cone-type spindle RC3-50-1 mit einer Drehgeschwindigkeit von 3 rpm bei 25°C bestimmt.

Bevorzugt ist daher der Einsatz von Organopolysilazanen, insbesondere solchen der Formel (I), die NH und SiH Bindungen enthalten und die durch katalytische Einwirkung von Fluoridionen vernetzt wurden. Bevorzugt ist daher ein Verfahren zur Herstellung von erfindungsgemäß eingesetzten Polysilazanen und dem daraus hergestellten Hybridmaterial, wobei ein oder mehrere Organopolysilazane, bevorzugt solche der Formel (I) und vorzugsweise mit mittleren Molgewichten M_{w} von weniger als 3000 g/mol, durch Behandeln mit einem Fluoridkatalysator vernetzt und anschließend mit dem oberflächenmodifizierten nanoskaligen anorganischen Oxid versetzt werden.

Die Komponente b) des Hybridmaterials besteht aus einem oder mehreren Typen von anorganischen oxidischen Nanopartikeln (d.h. nanoskaligem anorganischem Oxid) mit einem mittleren Durchmesser im Bereich von 1 bis 30 nm, bevorzugt 3 bis 20 nm.

Der mittlere Durchmesser wird dadurch gemessen, dass dynamisches Licht an den dispergierten Nanopartikeln gestreut wird, bevorzugt unter Verwendung eines MALVERN Zetasizer Nano Z, mit einer Wellenlänge von 633 nm.

In einer bevorzugten Ausführungsform liegt der Refraktionsindex der anorganischen Nanopartikel in dem Bereich von 1,40 bis 3,00, bevorzugt von 1,4 bis 2,50, besonders bevorzugt von 1,40 bis 2,30.

Die Nanopartikel werden aus Metalloxidnanopartikeln gewählt.

Bevorzugt werden die anorganischen Nanopartikel gewählt aus der Gruppe von Metalloxidnanopartikeln, die Oxide eines Metalls, ausgewählt aus Silizium (Si), Titan (Ti), Kobalt (Co), Zinn (Sn), Aluminium (Al), Zink (Zn), Indium (In), Zirconium (Zr), Nickel (Ni), Hafnium (Hf), Vanadium (V) oder einer Kombination, die mindestens zwei der vorstehend erwähnten Metalloxide enthält. Stärker bevorzugte Nanopartikels werden gewählt aus Al₂O₃, SiO₂, ZrO₂ und TiO₂, besonders SiO₂, TiO₂ und ZrO₂ und am meisten bevorzugt aus SiO₂ und ZrO₂.

Geeignete anorganische Partikel sind über die spektrale Bandbreite der Emissions-LED und die die Emission des Wellenlängenkonverters im Wesentlichen nicht absorbierend. Die Größe und Dichte der Partikel kann so gewählt werden, dass die gewünschten Grade von Transmission und Streuung erreicht werden.

Die anorganischen Nanopartikel werden oberflächenmodifiziert, um eine einheitliche Dispergierung im Hybridmaterial zu fördern. Um die Kompatibilität der Nanopartikel mit den verschiedenen Lösungs- oder Dispergiermitteln und mit der Polymermatrix sicherzustellen und Aggregationen zu verhindern, ist es nötig, die Oberfläche der Nanopartikel zu schützen. Ein weiterer Zweck des Oberflächenschutzes ist es, die Nanopartikel mit zusätzlichen Funktionalitäten zu versehen, wie zum Beispiel Doppelbindungen.

Typische Verbindungen, um die Oberfläche der Nanopartikel zu modifizieren, sind Organosilane, organische Amine, organische Thiole, organische Alkohole, Trialkylphosphine, Carbonsäuren, Phosphonsäuren, phosphorige Säure, Zirconate, Titanate. Organosilane sind eine bekannte Klasse organischer Verbindungen, die verwendet werden, um die Oberfläche von oxidischen Nanopartikeln zu schützen. Organosilane sind typischerweise aus einem reaktiven und einem nicht reaktiven Teil zusammengesetzt. Der reaktive Teil des Organosilans ist typischerweise entweder eine Trialkoxysilan Gruppe, eine Monoalkoxysilan Gruppe oder eine Trichlorsilan Gruppe, obwohl bisubstituierte Alkoxy und bi und mono substituierte Chlorsilane ebenfalls möglich sind. Die reaktive Gruppe bindet an das Oxid mit einer kovalenten Bindung mit der Hydroxygruppe oder der -OR Gruppe, wobei in R sich eine Alkyl- oder Arylgruppe befindet. Der nicht reaktive Teil des Organosilans kann eine oder mehrere Alkylketten mit verschiedener Kettenlänge beinhalten, eine oder mehrere einer zyklischen Alkylgruppe von verschiednener Kettenlänge, fluorierte Alkylgruppen, Alkenylgruppen, Epoxidgruppen, Arylgruppen, Ethergruppen, Amine, Thiole oder Carbonsäuren. Die Organosilane haben allgemein die Struktur RₐSi(OR')_{b}, wobei a = 1, 2 oder 3 ist, b = 4 - a, R und R' organische Reste sind, wobei R' bevorzugt Methyl, Ethyl, n- oder iso-Propyl und n- or iso-Butyl ist. In einer bevorzugten Ausführungsvariante handelt es sich bei oberfächenmodifizierenden Verbindung um ein Trialkoxysilan oder ein Trichlorsilan, wobei in jedem Fall eine C₁-C₁₈-Alkyl- oder C₂-C₁₈-Alkenylgruppe an das Siliziumatom gebunden ist. Bevorzugt sind C₁-C₆-Alkylgruppen oder C₂-C₆-Alkenylgruppen, stärker bevorzugt sind C₁-C₃-Alkyl oder C₂-C₃-Alkenyl, insbesondere Vinyl und Allyl.

Beispiele für Organosilane umfassen Methyltrimethoxysilan, Methyltriethoxysilan, Trimethylmethoxysilan, Trimethylethoxysilan, n-Propyltrimethoxysilan, n-Propyltriethoxysilan, Isobutyltrimethoxysilan, n-Hexyltrimethoxysilan, n-Octyltrimethoxysilan, n-Octyltriethoxysilan, 1.2.Bis(trimethoxysilyl)decan, Phenyltrimethoxysilan, 4-Phenylbutyltrimethoxysilan, Acetoxymethyltrimethoxysilan, Acetoxyethyltriethoxysilan, Hydroxylmethyltriethoxysilane, Hydroxy(polyethylenoxy)propyltriethoxysilane, 2-Methoxy(polyethylenoxy)propyltrimethoxysilan, Methoxy(triethylenoxy)propyltrimethoxysilan, 3-Aminopropyltrimethoxysilan, p-Aminophenyltrimethoxysilan, 3-Mercaptopropyltrimethoxysilan, 3-(Methacryloyloxy)propyltrimethoxysilan, Vinyltrimethoxysilan, Vinyltriethoxysilan, Allyltrimethoxysilan, 3-Isocyanatopropyltrimethoxysilan, 3-Isocyanatopropyltriethoxysilan, Glycidiloxypropyltrimethoxysilan, 2-(3.4-Epoxycyclo-hexyl)ethyltrimethoxysilan, 3.3.3-Trifluoropropyltrimethoxysilan und Nonanfluorohexyltrimethoxysilan. Methyltrimethoxysilan, Propylyltrimethoxysilan, Vinyltrimethoxysilan und Trimethylmethoxysilan sind besonders bevorzugt.

Bevorzugt für die Oberflächenbehandlung sind Alkoxysilane der Formel (V)

R"ₙSi(OR''')ₘ (V)

wobei
- n: 1, 2 oder 3 ist und m 4 - n ist;
- R": Methyl-, Ethyl-, lineares, verzweigtes oder zyklisches Alkyl mit 3-8 Kohlenstoffatomen, Phenyl oder (C₂-C₆)-Alkenyl ist und
- R'": Methyl, Ethyl, n- oder Iso-propyl, n- oder Isobutyl ist.

Bevorzugt sind Alkoxysilane der Formel (V), wobei
- n: 1 oder 3 ist und m 4 - n ist;

- R": Methyl-, Ethyl-, lineares oder verzweigtes (C₃-C₈)-Alkyl, Phenyl oder Vinyl ist und
- R'": Methyl oder Ethyl ist.

Besonders bevorzugt sind Alkoxysilane der Formel (V), wobei
- n: 1 oder 3 ist und m 4 - n ist;
- R": Methyl-, Ethyl oder lineares oder verzweigtes (C₃-C₈)-Alkyl ist und
- R'": Methyl oder Ethyl ist.

Die Gruppen R" und R"', sind jeweils und unabhängig voneinander gleich oder verschieden. Bevorzugt sind alle Gruppen R" in einer Verbindung, und, davon unabhängig, alle Gruppen R" in einer Verbindung gleich.

Bevorzugt sind erfindungsgemäße Hybridmaterialien, bei denen die oberflächenmodifizierende Verbindung ein Alkoxysilan der Formel (V) ist, eine bevorzugte oder besonders bevorzugte Ausführungsform davon oder eine Mischung daraus.

Andere Klassen von organischen Verbindungen, die verwendet werden, um ein oxidisches Nanomaterial zu modifizieren, sind Carbonsäuren und Alkohole. Beispiele für Carbonsäuren umfassen Octansäure, Essigsäure, Propionsäure, 2-[2-(2-methoxyethoxy)ethoxy]-Essigsäure, Benzoesäure, Oleinsäure und Stearinsäure.

Beispiele für Alkohole umfassen Ethanol, Propanol, Butanol, Hexanol, Heptanol, Octanol, Benzylalkohol, Phenol, Dodecylalkohol, Oleylalkohol, Octadecanol und Triethylenglykolmonomethylether.

Die anorganischen Nanopartikel der Erfindung sind bevorzugt monodispers. In einer bevorzugten Ausführung beträgt die Menge der Partikel mit einem Durchmesser von > 20 nm ≤ 10,0 % nach Gewicht, die Menge der Partikel mit einem Durchmesser von >30 nm beträgt ≤ 1,0 % nach Gewicht, und die Menge der Partikel mit einem Durchmesser von > 50 nm beträgt ≤ 0,1 %, wobei % jeweils Gew.-% bedeutet.

Die Verteilung wird durch dynamische Lichtstreuung der dispergierten Nanopartikel bestimmt, wobei ein MALVERN Zetasizer Nano Z Gerät bei einer Wellenlänge von 633 nm verwendet wird.

Das erfindungsgemäße Hybridmaterial kann mit den Methoden hergestellt werden, die in der US 2012/0088845 offenbart sind.

In einer Ausführungsform wird das Organopolysilazanmaterial in einem geeigneten Lösungsmittel aufgelöst. Im Allgemeinen handelt es sich hierbei um dipolar protische Lösungsmittel wie THF, und wird mit einer Dispersion der anorganischen Nanopartikel in einem geeigneten Lösungsmittel, zum Beispiel einem alkylierten aromatischen Kohlenwasserstoff wie Toluol, versetzt. Das Lösungsmittel wird dann entfernt, im Allgemeinen durch Destillation, und das Rohprodukt gegebenenfalls im Vakuum getrocknet.

Die Menge von anorganischen Nanopartikeln im Hybridmaterial ist im Allgemeinen im Bereich von 1 bis 85 Gew.-%, vorzugsweise 10 bis 75 Gew.-%, besonders bevorzugt 10 bis 50 Gew.-%.

Weitere Bestandteile des erfindungsgemäß eingesetzten Hybridmaterials sind gegebenenfalls Additive, welche beispielsweise die Viskosität der Zusammensetzung, Benetzung, Filmbildung oder das Verdampfungsverhalten positiv beeinflussen. Weiterhin kann das erfindungsgemäße Hybridmaterial bis zu 10 Gew.-% an einem oder mehreren, von den Nanopartikeln verschiedenen anorganischen Füllstoffen enthalten.

Das Hybridmaterial kann bis zu 60 Gew.-% an Konvertern, Haftungsvermittlern und/oder Weichmachern beinhalten.

Um eine Mischung des Hybridmaterials mit Zusatzstoffen herzustellen, werden die Komponenten im Allgemeinen in einem Lösungsmittel oder einer Lösungsmittelmischung aufgelöst oder dispergiert. Das Lösungsmittel wird dann, z.B. durch Destillation, entfernt. Geeignete Lösungsmittel sind, z.B. unpolare oder polare nichtprotische Lösungsmittel wie Ether, zyklische Ether, Ester, z.B. THF oder PGMEA, aromatische Lösungsmittel wie Toluol oder Alkane wie Heptan oder Cyclohexan.

Im Folgenden wird das erfindungsgemäße Beschichtungsmittel beschrieben.

Das Gewichtsverhältnis von Organopolysilazanen zu oberflächenmodifizierten Nanopartikeln liegt im Bereich von 99:1 bis 15:85 Gew.-%.

In einer bevorzugten Ausführungsform werden erfindungsgemäß verwendete Polysilazane als solche, d. h. ohne weitere Verdünnung, eingesetzt. Geeignet für eine solche Anwendung sind z. B. bei Raumtemperatur flüssige Materialien.

In einer weiteren bevorzugten Ausführungsform der Erfindung wird das erfindungsgemäß eingesetzte Hybridmaterial in einem Lösungsmittel als Beschichtungsmittel aufgebracht.

Üblicherweise beträgt der Anteil des Hybridmaterials in dem Lösungsmittel 1 bis 90 Gew.-% Polysilazan, bevorzugt 5 bis 75 Gew.-%, besonders bevorzugt 10 bis 70 Gew.-%.

Geeignete Lösungsmittel für die Polysilazanzusammensetzung umfassen insbesondere inerte (insbesondere Hydroxy- und Aminogruppen freie), organische Lösungsmittel. Das sind beispielsweise aliphatische oder aromatische Kohlenwasserstoffe, halogenierte Kohlenwasserstoffe, Ester wie Ethylacetat oder Butylacetat, Ketone wie Aceton oder Methylethylketon, Ether wie Tetrahydrofuran, Dioxan or Dibutylether, und auch Mono- und Polyalkylenglycoldialkylether (Glymes), oder Mischungen dieser Lösungsmittel.

Das erfindungsgemäße Hybridmaterial eignet sich als Beschichtungsmittel zur Herstellung transparenter Schichten mit einer Schichtdicke von weniger als 500 µm, bevorzugt von 0.1µm bis 450 µm, besonders bevorzugt von 0.3µm bis 250. µm. Die Schichtdicke kann nach dem Fachmann bekannten Methoden ermittelt werden, beispielsweise durch mechanische-, Ultraschall-, oder optische Messungen. Mechanische Messungen können z.B. mit Messuhren oder Messchrauben vorgenommen werden. So wurden Schichtdicken von etwa 10 µm bis 500 µm mit einem MarCator Digital Indicator 1086 ZR von Mahr gemessen. Dünne Schichten bis 10 µm können durch taktile Profilomerter, z.B. mit einem Dektak Profilometer von Bruker bestimmt werden.

Weiterhin Gegenstand der Erfindung ist daher ein Verfahren zum Beschichten einer Fläche eines optoelektronischen Bauteils, wobei man ein erfindungsgemäßes Hybridmaterial auf die gewünschte Fläche aufbringt, trocknet und gegebenenfalls härtet.

Das erfindungsgemäß eingesetzte Hybridmaterial kann nach üblichen Methoden wie Aufschleudern, Rakeln, Eintauchen und Sprühen auf die gewünschte Fläche aufgebracht werden. Dazu können beispielsweise kommerziell erhältliche Dispensiersysteme verwendet werden.

Vor dem Aufbringen der erfindungsgemäßen Polysilazanzusammensetzung kann das Substrat gegebenenfalls mit einem Haftungsverbesserer behandelt warden, um die Haftung der Polysilazanzusammensetzung an das Substrat weiter zu verbessern. Typische Haftungsverbesserer basieren auf Silanen, wie 3-Aminopropyltriethoxysilan, 3-Glycidyloxypropyltriethoxysilan, 3-Mercaptopropyltrimethoxysilan, Vinyltriethoxysilan, 3-Methacryloyloxypropyltrimethoxysilan, N-(2-Aminoethyl)-3-aminopropyltrimethoxysilan, Bis(3-triethoxysilylpropyl)amin, N-(n-Butyl)-3-aminopropyltrimethoxysilan, und N-(2-Aminoethyl)-3-aminopropylmethyldimethoxysilan.

Nach dem Aufbringen der Polysilazanzusammensetzung erfolgt ein Trocknungsschritt.

Das Trocknen von Hybridmaterial, das ein festes Organopolysilazanmaterial enthält, kann durch einfaches Eintrocknen erfolgen.

Das Trocknen von Hybridmaterial, das gegebenenfalls ein ölartiges Organopolysilazanmaterial enthält, erfolgt bevorzugt durch teilweise Kondensationsreaktion mit Feuchtigkeit, beispielsweise im Klimaschrank optional unter Zusatz von Katalysatoren, welche die Reaktion mit Luftfeuchtigkeit katalysieren.

Erfindungsgemäße Beschichtungen, die einen Alkenylrest, insbesondere Vinyl, am Silizium enthalten, können durch chemische Vernetzung der Schichten unter Temperatureinfluss gehärtet werden, beschleunigbar durch Zugabe von Katalysatoren, die Radikale erzeugen (wie z.B. organische Peroxyde oder AzoVerbindungen) oder Edelmetall-Katalysatoren (wie z.B. Pt oder Pd Komplexe) oder durch Bestrahlung mit sichtbarem oder UV-Licht in Gegenwart eines Photoinitiators .

Dem Fachmann ist bekannt, dass während des Trocknungsschrittes, insbesondere in einer sauerstoff- und/oder feuchtigkeitshaltigen Atmosphäre von Raumluft, und auch während des Betriebs des optoelektronischen Bauteils, bei dem die Beschichtung erhöhten Temperaturen und Sauerstoff ausgesetzt sein kann, ein Teil der -SiR₂-NH Gruppen in dem Organopolysilazanmaterial in -SiO - Gruppen umgewandelt wird.

In einer bevorzugten Ausführungsform der Erfindung bleibt jedoch die Mehrheit, bevorzugt > 80 %, besonders bevorzugt > 85 % und insbesondere bevorzugt > 90 % (mit FTIR bestimmt) der -SiR₂-NH Gruppen erhalten.

Bevorzugt für diese Ausführungsform sind feste Organopolysilazane, insbesondere solche mit einem hohen Vernetzungsgrad und einem Molgewicht größer als 6000g/mol.

Bevorzugt ist aber auch ein Hydrolyseprozess, bei dem die Organopolysilazankomponente des Hybridmaterials überwiegend bis vollständig in ein Organopolysiloxan umgewandelt wird.

Der Hydrolyseprozess läuft bevorzugt bei einer relativen Luftfeuchtigkeit von ≥ 50 %, besonders bevorzugt ≥ 70 %, insbesondere ≥ 75 % und eine Temperatur von > 50°C, bevorzugt > 60°C und besonders bevorzugt > 75°C.

Eine Beschleunigung der Hydrolyse durch Zusatz von Basen oder Edelmetall-Verbindungen als Katalysatoren ist möglich, wobei sich die oben genannten Basen und Edelmetall-Verbindungen eignen.

Für den Hydrolyseprozess bevorzugt sind Organopolysilazane, die bei Raumtemperatur ölartig bis wachsartig sind (d.h. kein Feststoff) mit einem Molgewicht < 6000g/mol.

Neben dem Aushärten durch konventionelles Erhitzen ist es auch möglich, Strahlungstrockner basierend auf IR oder NIR Technologie zu benutzen. In solchen Fällen werden die Trockner üblicherweise in einem Wellenlängenbereich 12 bis 1.2 Mikrometer oder 1.2 bis 0.8 Mikrometer betrieben. Typische Strahlungsintensitäten liegen im Bereich von 5 bis 1000 kW/m².

Weiterhin Gegenstand der Erfindung ist ein optoelektronisches Bauelement, enthaltend mindestens eine Schicht, die aus dem erfindungsgemäßen Beschichtungsmittel hergestellt wurde. Eine solche Schicht besteht aus dem erfindungsgemäßen Hybridmaterial oder dessen Trocknungs- und/oder Härtungsprodukt.

Das erfindungsgemäße Hybridmaterial eignet sich zur Herstellung transparenter Schichten mit einer Schichtdicke < 500 µm für optoelektronische Bauelemente.

In einer bevorzugten Ausführungsform liegt der Brechungsindex n im Bereich von 1,45 bis 1,85. Der Brechungsindex n ist definiert als n = c/v, wobei c die Lichtgeschwindigkeit im Vakuum und v die Lichtgeschwindigkeit in dem Material, dessen Brechungsindex bestimmt wird, bedeuten. n wird bei 594 nm und 20 °C bestimmt.

Transparent bedeutet erfindungsgemäß eine Lichtdurchlässigkeit von ≥ 99 % bei einer Schichtdicke von 0.5 mm und einer Wellenlänge von 450 nm.

Als optoelektronische Bauelemente sind LED und Bildschirme bevorzugt.

Die erfindungsgemäße Beschichtung eignet sich bevorzugt als Bindermaterial für Schichten in LED, welche Leuchtmittel (Phosphor) und/oder einen Converter enthalten. Ebenfalls geeignet ist eine Verwendung als Klebeschicht (Adhäsionsschicht).

Erfindungsgemäße Beschichtungen zeigen vorzugsweise kein Vergilben bei einer Temperaturbelastung bis 250 °C und Bestrahlung mit Licht bei einer Wellenlänge von ≥ 400 nm.

Die erfindungsgemäße Beschichtung kann in einer Vielfalt von LED-Vorrichtungen eingesetzt werden, beispielsweise LED mit hoher Lichthelligkeit (HBLED), Oberflächenemitter-Lase (VCSEL), Laserdioden, Flachbildschirmen, Projektionsdisplays für optische Komponenten, spritzgussfähige optische Linsen und andere optische Teile, Vorrichtungen und Strukturen. Sie kann weiterhin als Teil von Photohalbleiter-Vorrichtungen, die mit blauen oder weißen LED-Elementen bestückt sind verwendet werden. LED, welche erfindungsgemäße Schichten enthalten, können als Hintergrundbeleuchtung für Flüssigkristalldisplays, Ampeln, Werbeflächen usw. eingesetzt werden.

Ein typischer LED-Aufbau gemäß der Erfindung enthält einen LED-Chip, ggf. einen Bleirahmen, ggf. Golddraht, ggf. Lötmetall, ggf. Füllmaterial, ggf. ein Verkapselungsmaterial und primäre und sekundäre Optik.

Die erfindungsgemäße Beschichtung eignet sich beispielsweise zum Einsatz in LED, wie sie in der US 6,274,924 und US 6,204,523 beschrieben sind.

Die Erfindung wird durch die Beispiele näher erläutert, ohne sie dadurch zu beschränken.

### Beispiele

Herstellung von erfindungsgemäß eingesetzten Polysilazanen durch Fluoridionen-Katalysierte-Vernetzung von DURAZANE 1033 und DURAZANE 1800

### Beispiel 1

In einem 250ml Kolben wurden unter Stickstoffatmosphäre und sorgfältigem Feuchtigkeitsausschuss 50g DURAZANE 1033 und 50g n-Heptan gemischt. Bei Raumtemperatur wurden 0,5g Tetramethylammoniumfluorid zugegeben. Die Reaktionslösung wurde innerhalb von 2h auf 60°C erwärmt und so lange bei 60°C gerührt, bis die Gasentwicklung stoppte (nach ca. 2h). Nach Abkühlen auf 0°C wurden 200ml n-Heptan zugegeben und ausgefallenes Salz wurde abfiltriert. Die Reaktionslösung wurde am Rotationsverdampfer zunächst bis auf ein Volumen von ca. 100ml eingeengt und dann erneut filtriert. Danach wurde die Reaktionslösung am Rotationsverdampfer bis zur Trockene eingeengt. Es verblieben 48g eines farblosen zähen Öls.

### Beispiel 2

In einem 250ml Kolben wurden unter Stickstoffatmosphäre und sorgfältigem Feuchtigkeitsausschuss 50g DURAZANE 1033 und 50g THF gemischt. Bei 0°C wurden 0,5g Tetramethylammoniumfluorid zugegeben. Es war eine spontane Gasentwicklung zu beobachten. Die Reaktionslösung wurde innerhalb von 4h auf 40°C erwärmt und so lange bei 40°C gerührt, bis die Gasentwicklung stoppte (ca. 2h). Nach Abkühlen auf 0°C wurden 200ml n-Heptan zugegeben und ausgefallenes Salz wurde abfiltriert. Die Reaktionslösung wurde am Rotationsverdampfer zunächst bis auf ein Volumen von ca. 100ml eingeengt und dann erneut filtriert. Danach wurde die Reaktionslösung am Rotationsverdampfer bis zur Trockene eingeengt. Es verblieben 45g eines farblosen glasartigen Feststoffs.

### Beispiel 3

In einem 250ml Kolben wurden unter Stickstoffatmosphäre und sorgfältigem Feuchtigkeitsausschuss 50g DURAZANE 1800 und 50g Acetonitril gemischt. Bei Raumtemperatur wurden 0,5g Cäsiumfluorid zugegeben. Die Reaktionslösung wurde innerhalb von 2h auf 60°C erwärmt und so lange bei 60°C gerührt, bis die Gasentwicklung stoppte (ca. 2h). Nach Abkühlen auf 0°C wurden 200ml Di-n-Butylether zugegeben und das ausgefallene Salz wurde abfiltriert. Die Reaktionslösung wurde am Rotationsverdampfer zunächst bis auf ein Volumen von ca. 100ml eingeengt und dann erneut filtriert. Danach wurde die Reaktionslösung am Rotationsverdampfer bis zur Trockene eingeengt. Es verblieben 47g eines farblosen bis leicht hellgelben glasartigen Feststoffs.

### Beispiel 4

In einem 250ml Kolben wurden unter Stickstoffatmosphäre und sorgfältigem Feuchtigkeitsausschuss 50g DURAZANE 1800 und 50g THF gemischt. Bei 0°C wurden 0,5g Tetraethylammoniumfluorid zugegeben. Es war eine spontane Gasentwicklung zu beobachten. Die Reaktionslösung wurde innerhalb von 2h auf 20°C erwärmt und so lange bei 20°C gerührt, bis die Gasentwicklung stoppte (ca. 4h). Nach Abkühlen auf 0°C wurden 200ml n-Heptan zugegeben und ausgefallenes Salz wurde abfiltriert. Die Reaktionslösung wurde am Rotationsverdampfer zunächst bis auf ein Volumen von ca. 100ml eingeengt und dann erneut filtriert. Danach wurde die Reaktionslösung am Rotationsverdampfer bis zur Trockene eingeengt. Es verblieben 46g eines farblosen glasartigen Feststoffs.

**Tabelle 1 Zusammenstellung der Beispiele**

| Bei-spiel | Rohstoff | Lösemittel | KatalySator | Temperatur | Molgewicht* | Konsistenz | η [mPas] |
|---|---|---|---|---|---|---|---|
| 1. | DURAZANE 1033 | n-Heptan | NMe₄F | 60°C | 5200 | flüssig/Öl | ca. 5000 |
| 2. | DURAZANE 1033 | THF | NMe₄F | 40°C | 10300 | fest | - |
| 3. | DURAZANE 1800 | Acetonitril | CsF | 60°C | 12700 | fest | -- |
| 4. | DURAZANE 1800 | THF | NEt₄F | 20°C | 13900 | fest | -- |
| DURAZANE 1033 | -- | -- | -- | -- | 2500 | flüssig | 19 |
| DURAZANE 1800 | -- | -- | -- | -- | 2800 | flüssig | 80 |

| | | | | | | | |
|---|---|---|---|---|---|---|---|
| *das Molgewicht wurde durch GPC (Gelpermeationschromatographie) gegen Polystyrolstandards bestimmt | | | | | | | |

Vergleich von Beispiel 1 mit Beispiel 2 zeigt, dass durch die Wahl der Reagenzien das Ausmaß der Vernetzungsreaktion gezielt gesteuert werden kann. Bei bewusst geringer Vernetzung erhält man ein Produkt mittleren Molgewichts mit flüssiger, zäher bis ölartiger Konsistenz (Bsp.1.) und bei hoher Vernetzung erhält man ein Produkt das als Feststoff anfällt (Bsp.2.).

Von DURAZANE 1033 und dem vernetzten Produkt aus Bsp.2. wurde eine Thermogravimetrische Analyse durchgeführt (TGA: Gewichtsverlust beim Erhitzen). Von DURAZANE 1800 und dem vernetzten Produkt aus Bsp.3. wurde ebenfalls ein TGA aufgenommen. Die Ergebnisse sind in Figur 1 zusammengestellt.

Der Vergleich der niedermolekularen Ausgangsprodukte mit den entsprechenden vernetzten Produkten zeigt eine deutliche Abnahme der verdampfbaren Anteile der vernetzten Produkte.

Der Vergleich der GPC Spektren von DURAZANE 1033, DURAZANE 1800 und der entsprechenden zum Feststoff vernetzten Produkte aus Beispiel 2 und Beispiel 3 zeigt deutlich das höhere Molgewicht bei gleichzeitig verringertem Anteil an Oligomeren.

Mit einer Lösung DURAZANE 1033 in Dibutylether und einer Dibutylether-Lösung des vernetzten Produkt aus Beispiel 2 wurde durch Spincoating ein 3 Zoll Wafer mit einer 1,0 µm dicken Schicht belackt. Anschließend wurde der Wafer auf einer Heizplatte für 1h bei 200°C gebacken. Nach Abkühlen auf Raumtemperatur wurde mit einem Dektak Profilometer (mechanisches Schichtdickenmessgerät) die Schwankung der Schichtdicke quer über den Wafer gemessen. Derselbe Vergleich wurde mit DURAZANE 1800 und dem vernetzten Produkt aus Beispiel 3 durchgeführt.

Ein Vergleich der niedermolekularen Ausgangsprodukte mit den entsprechenden vernetzten Produkten zeigt eine deutliche reduzierte Schwankung der Schichtdicke bei den mit vernetzten Produkten beschichteten Wafern. Aus diesem Resultat kann abgeleitet werden, dass die erfindungsgemäß vernetzten Produkte wesentlich verbesserte Beschichtungseigenschaften aufweisen.

## Patentansprüche

1. Verwendung eines Hybridmaterials, enthaltend
a) ein Organopolysilazanmaterial und
b) mindestens ein oberflächenmodifiziertes nanoskaliges anorganisches Oxid
als Beschichtungsmaterial zur Herstellung transparenter Schichten mit einer Dicke von weniger als 500 µm in optoelektronischen Bauteilen, wobei das Organopolysilazanmaterial Wiederholungseinheiten der Formel (I) enthält,
- [SiRR'-NH] (I)
wobei R, R' gleich oder verschieden H, Methyl, Ethyl, geradkettiges oder verzweigtes C₃-C₈-Alkyl, C₃-C₈-Cycloalkyl, C₂-C₆-Alkenyl oder Aryl bedeuten, wobei R und R' nicht gleichzeitig H sein können, und wobei mindestens 20% der Wiederholungseinheiten der Formel (I) mindestens eine intramolekulare Vernetzung aufweisen.

2. Verwendung nach Anspruch 1, wobei in der Formel (I) R, R' gleich oder verschieden H, Methyl, Ethyl, geradkettiges, verzweigtes oder cyclisches C₃-C₈-Alkyl, Phenyl, Vinyl oder Aryl bedeuten.

3. Verwendung nach Anspruch 2, wobei in der Formel (I) R, R' gleich oder verschieden H, Methyl, Ethyl, n-Propyl, iso-Propyl, n-Butyl, iso-Butyl, Phenyl oder Vinyl bedeuten.

4. Verwendung nach Anspruch 3, wobei in der Formel (I) R, R' gleich oder verschieden H, Methyl oder Vinyl bedeuten.

5. Verwendung gemäß einem der Ansprüche 1 bis 4, wobei das Organopolysilazanmaterial durch die katalytische Einwirkung von Fluoridionen vernetzt wurde.

6. Verwendung gemäß einem der Ansprüche 1 bis 5, wobei die Komponente b) des Hybridmaterials aus einem oder mehreren Typen von anorganischen oxidischen Nanopartikeln mit einem mittleren Durchmesser im Bereich von 1 bis 30 nm, bevorzugt 3 bis 20 nm, besteht, wobei der Durchmesser durch dynamische Lichtstreuung, wie in der Beschreibung erklärt, bestimmt wird.

7. Verwendung gemäß Anspruch 6, wobei die Nanopartikel ausgewählt sind aus Al₂O₃, SiO₂, ZrO₂ und TiO₂, bevorzugt SiO₂, TiO₂ und ZrO₂, besonders bevorzugt TiO₂ und ZrO₂.

8. Verwendung gemäß einem der Ansprüche 1 bis 7, wobei die Oberflächenmodifikation der Nanopartikel durch Alkoxysilane der Formel (V) erfolgt,
R"ₙSi(OR''')ₘ (V)
wobei
n 1, 2 oder 3 ist und m 4 - n ist;
R" Methyl-, Ethyl-, lineares, verzweigtes oder zyklisches Alkyl ist, mit 3-8 Kohlenstoffatomen, Phenyl, (C₂-C₆)-Alkenyl; und
R'" Methyl, Ethyl, n- oder Iso-propyl, n- oder Isobutyl ist.

9. Verwendung gemäß Anspruch 8, wobei in der Formel (V)
n 1 oder 3 ist und m 4 - n ist;
R" Methyl-, Ethyl-, lineares oder verzweigtes (C₃-C₈)-Alkyl, Phenyl oder Vinyl ist; und
R'" Methyl oder Ethyl ist.

10. Verwendung gemäß Anspruch 9, wobei in der Formel (V)
n 1 oder 3 ist und m 4 - n ist;
R" Methyl-, Ethyl oder lineares oder verzweigtes (C₃-C₈)-Alkyl ist, und
R'" Methyl oder Ethyl ist.

11. Verwendung gemäß einem der Ansprüche 1 bis 10, wobei die Menge von anorganischen Nanopartikeln im Hybridmaterial im Bereich von 1 bis 85 Gew.-% liegt.

12. Verwendung nach einem der Ansprüche 1 bis 11, wobei das optoelektronische Bauelement eine LED oder ein Bildschirm ist.

13. Verwendung nach Anspruch 12, wobei das optoelektronische Bauelement eine LED ist und die Beschichtung Leuchtmittel und/oder Converter enthält.

14. Verfahren zum Aufbringen einer transparenten Schicht mit einer Dicke von < 500 µm in einem optoelektronischen Bauelement, wobei
I) ein Hybridmaterial wie in einem der Ansprüche 1 bis 11 beschrieben auf eine Fläche in dem optoelektronischen Bauelement aufgebracht,
II) getrocknet, und
III) gegebenenfalls gehärtet wird.

15. Verfahren gemäß Anspruch 14, wobei das Hybridmaterial erhalten wird durch Bereitstellung eines oder mehrerer Organopolysilazane der Formel (I), Vernetzung der Polysilazane der Formel (I) durch Behandlung mit einem Fluoridkatalysator und Mischen mit dem oberflächenmodifizierten nanoskaligen anorganischen Oxid.

16. Verfahren gemäß Anspruch 14 oder 15, wobei in Schritt III) das Organopolysilazanmaterial durch Hydrolyse bei Temperaturen > 150°C teilweise oder vollständig in ein Organopolysiloxan umgewandelt wird.

17. Verfahren gemäß Anspruch 16, wobei Schritt III) bei einer Temperatur > 50°C, bevorzugt > 60°C und bei einer relativen Luftfeuchtigkeit von > 50%, bevorzugt > 70% durchgeführt wird.

18. Optoelektronisches Bauteil, enthaltend eine oder mehrere Schichten, erhalten aus einem Hybridmaterial wie in einem der Ansprüche 1 bis 11 beschrieben.

## Claims

1. Use of a hybrid material comprising
a) an organopolysilazane material and
b) at least one surface-modified nanoscale inorganic oxide as coating material for the production of transparent layers having a thickness of less than 500 µm in optoelectronic components, where the organopolysilazane material contains recurring units of the formula (I),
- [SiRR'-NH] (I)
where R, R' denote, identically or differently, H, methyl, ethyl, straight-chain or branched C₃-C₈-alkyl, C₃-C₈-cycloalkyl,, C₂-C₆-alkenyl or aryl, where R and R' cannot simultaneously be H, and where at least 20% of the recurring units of the formula (I) have at least one intramolecular crosslinking.

2. Use according to Claim 1, where, in formula (I),
R, R' denote, identically or differently, H, methyl, ethyl, straight-chain, branched or cyclic C₃-C₈-alkyl, phenyl, vinyl or aryl.

3. Use according to Claim 2, where, in formula (I),
R, R' denote, identically or differently, H, methyl, ethyl, n-propyl, iso-propyl, n-butyl, isobutyl, phenyl or vinyl.

4. Use according to Claim 3, where, in formula (I), R, R' denote, identically or differently, H, methyl or vinyl.

5. Use according to one of Claims 1 to 4, where the organopolysilazane material has been crosslinked by the catalytic action of fluoride ions.

6. Use according to one of Claims 1 to 5, where component b) of the hybrid material consists of one or more types of inorganic oxidic nanoparticles having an average diameter in the range from 1 to 30 nm, preferably 3 to 20 nm, where the diameter is determined by dynamic light scattering, as explained in the description.

7. Use according to Claim 6, where the nanoparticles are selected from Al₂O₃, SiO₂, ZrO₂ and TiO₂, preferably SiO₂, TiO₂ and ZrO₂, particularly preferably TiO₂ and ZrO₂.

8. Use according to one of Claims 1 to 7, where the surface modification of the nanoparticles is effected by alkoxysilanes of the formula (V),
R"ₙSi(OR''')ₘ (V)
where
n is 1, 2 or 3 and m is 4 - n;
R" is methyl, ethyl, linear, branched or cyclic alkyl having 3-8 carbon atoms, phenyl, (C₂-C₆)-alkenyl; and
R'" is methyl, ethyl, n- or isopropyl, n- or isobutyl.

9. Use according to Claim 8, where, in the formula (V),
n is 1 or 3 and m is 4 - n;
R" is methyl, ethyl, linear or branched (C₃-C₈)-alkyl, phenyl or vinyl; and
R'" is methyl or ethyl.

10. Use according to Claim 9, where, in the formula (V),
n is 1 or 3 and m is 4 - n;
R" is methyl, ethyl or linear or branched (C₃-C₈)-alkyl; and
R'" is methyl or ethyl.

11. Use according to one of Claims 1 to 10, where the amount of inorganic nanoparticles in the hybrid material is in the range from 1 to 85% by weight.

12. Use according to one of Claims 1 to 11, where the optoelectronic component is an LED or a display screen.

13. Use according to Claim 12, where the optoelectronic component is an LED and the coating comprises phosphors and/or converters.

14. Process for the application of a transparent layer having a thickness of < 500 µm in an optoelectronic component, where
I) a hybrid material as described in one of Claims 1 to 11 is applied to an area in the optoelectronic component,
II) dried, and
III) optionally cured.

15. Process according to Claim 14, where the hybrid material is obtained by provision of one or more organopolysilazanes of the formula (I), crosslinking of the polysilazanes of the formula (I) by treatment with a fluoride catalyst and mixing with the surface-modified nanoscale inorganic oxide.

16. Process according to Claim 14 or 15, where, in step III), the organopolysilazane material is partly or completely converted into an organopolysiloxane by hydrolysis at temperatures > 150°C.

17. Process according to Claim 16, where step III) is carried out at a temperature > 50°C, preferably > 60°C, and at a relative atmospheric humidity of > 50%, preferably > 70%.

18. Optoelectronic component comprising one or more layers obtained from a hybrid material described in one of Claims 1 to 11.

## Revendications

1. Utilisation d'un matériau hybride comprenant
a) un matériau d'organopolysilazane et
b) au moins un oxyde inorganique d'échelle nanométrique modifié en surface en tant que matériau de revêtement pour la fabrication de couches transparentes qui présentent une épaisseur inférieure à 500 µm dans les composants optoélectroniques, dans laquelle le matériau, d'organopolysilazane contient des unités récurrentes de la formule (I),
- [SiRR'-NH] (I)
dans laquelle R, R' représentent, de manière identique ou différente, H, méthyle, éthyle, C₃-C₈-alkyle en chaîne droite ou ramifié, C₃-C₈-cycloalkyle, C₂-C₆-alkényle ou aryle, dans laquelle R et R' ne peuvent pas être de façon simultanée H, et dans laquelle au moins 20 % des unités récurrentes de la formule (I) comportent au moins une réticulation intramoléculaire.

2. Utilisation selon la revendication 1, dans laquelle, dans la formule (I), R, R' représentent, de manière identique ou différente, H, méthyle, éthyle, C₃-C₈-alkyle en chaîne droite, ramifié ou cyclique, phényle, vinyle ou aryle.

3. Utilisation selon la revendication 2, dans laquelle, dans la formule (I), R, R' représentent, de manière identique ou différente, H, méthyle, éthyle, n-propyle, isopropyle, n-butyle, isobutyle, phényle ou vinyle.

4. Utilisation selon la revendication 3, dans laquelle, dans la formule (I), R, R' représentent, de manière identique ou différente, H, méthyle ou vinyle.

5. Utilisation selon l'une quelconque des revendications 1 à 4, dans laquelle le matériau d'organopolysilazane a été réticulé par l'action catalytique d'ions de fluorure.

6. Utilisation selon l'une quelconque des revendications 1 à 5, dans laquelle le composant b) du matériau hybride est constitué par un ou plusieurs type(s) de nanoparticules oxydiques inorganique qui présentent un diamètre moyen dans la plage de 1 à 30 nm, de préférence dans la plage de 3 à 20 nm, dans laquelle le diamètre est déterminé par diffusion de lumière dynamique, comme expliqué dans la description.

7. Utilisation selon la revendication 6, dans laquelle les nanoparticules sont sélectionnées parmi Al₂O₃, SiO₂, ZrO₂ et TiO₂, de préférence parmi SiO₂, TiO₂ et ZrO₂, de façon particulièrement préférable, parmi TiO₂ et ZrO₂.

8. Utilisation selon l'une quelconque des revendications 1 à 7, dans laquelle la modification en surface des nanoparticules est réalisée par des alcoxysilanes de la formule (V),
R"ₙSi(OR''')ₘ (V)
dans laquelle
n est 1, 2 ou 3 et m est 4 - n ;
R" est méthyle, éthyle, alkyle linéaire, ramifié ou cyclique qui comporte de 3 à 8 atomes de carbone, phényle, (C₂-C₆)-alkényle ; et
R'" est méthyle, éthyle, n- ou isopropyle, n- ou isobutyle.

9. Utilisation selon la revendication 8, dans laquelle, dans la formule (V),
n est 1 ou 3 et m est 4 - n ;
R" est méthyle, éthyle, (C₃-C₈)-alkyle linéaire ou ramifié, phényle ou vinyle ; et
R'" est méthyle ou éthyle.

10. Utilisation selon la revendication 9, dans laquelle, dans la formule (V),
n est 1 ou 3 et m est 4 - n ;
R" est méthyle, éthyle ou (C₃-C₈)-alkyle linéaire ou ramifié ; et
R'" est méthyle ou éthyle.

11. Utilisation selon l'une quelconque des revendications 1 à 10, dans laquelle la quantité de nanoparticules inorganiques dans le matériau hybride s'inscrit à l'intérieur de la plage qui va de 1 % à 85 % en poids.

12. Utilisation selon l'une quelconque des revendications 1 à 11, dans laquelle le composant optoélectronique est une LED ou un écran d'affichage.

13. Utilisation selon la revendication 12, dans laquelle le composant optoélectronique est une LED dont le revêtement comprend des phosphores et/ou des convertisseurs.

14. Procédé pour l'application d'une couche transparente qui présente une épaisseur < 500 µm dans un composant optoélectronique, dans lequel
I) un matériau hybride tel que décrit selon l'une quelconque des revendications 1 à 11 est appliqué sur une zone dans le composant optoélectronique,
II) il est séché, et
III) en option, il est durci.

15. Procédé selon la revendication 14, dans lequel le matériau hybride est obtenu au moyen de la fourniture d'un ou de plusieurs organopolysilazane(s) de la formule (I), au moyen de la réticulation des polysilazanes de la formule (I) à l'aide d'un traitement au moyen d'un catalyseur fluorure et au moyen d'un mélange avec l'oxyde inorganique d'échelle nanométrique modifié en surface.

16. Procédé selon la revendication 14 ou 15, dans lequel, au niveau de l'étape III), le matériau d'organopolysilazane est partiellement ou complètement converti selon un organopolysiloxane par hydrolyse à des températures > 150 °C.

17. Procédé selon la revendication 16, dans lequel l'étape III) est mise en œuvre à une température > 50 °C, de préférence > 60 °C, et à une humidité atmosphérique relative > 50 %, de préférence > 70 %.

18. Composant optoélectronique comprenant une ou plusieurs couche(s) qui est/sont obtenue(s) à partir d'un matériau hybride qui est décrit selon l'une quelconque des revendications 1 à 11.
